# EUROPEAN PATENT APPLICATION

(11) **EP 4 481 420 A1**
(43) Date of publication of application: **25.12.2024**
(21) Application number: 23179931.3
(22) Date of filing: 19.06.2023
(51) Int. Cl.: G01R 33/28

(54) **MAGNETIC RESONANCE EXAMINATION SYSTEM WITH AN EASY TO MAINTAIN SENSOR**

(71) Applicant: Koninklijke Philips N.V., 5656 AG Eindhoven (NL)
(72) Inventor: FORTHMANN, Peter, 5656AG Eindhoven (NL); LEUSSLER, Christoph Günther, 5656AG Eindhoven (NL)
(74) Representative: Philips Intellectual Property & Standards

(57) **Abstract**

The invention relates to a magnetic resonance examination system (1), comprising:
a sensor (2) for measuring physical quantities that are indicative for the operational status of the magnetic resonance examination system (1) and/or for measuring the vital signs of a patient to be examined in the magnetic examination system (1) and for outputting respective data,
an electrical energy storage device (3) for storing electrical energy and for providing the sensor (2) with electrical energy, and
an energy harvesting assembly (4) for generating electrical power from kinetic energy received by mechanical motion of at least a part of the energy harvesting assembly (4) and for transferring this electrical energy to the electrical energy storage device (3).

In this way, a magnetic resonance examination system with easy to maintain sensors may be provided.

## Description

### FIELD OF THE INVENTION

The invention relates to the field of magnetic resonance examination, and in particular to a magnetic resonance examination system comprising a sensor for measuring physical quantities that are indicative for the operational status of the magnetic resonance examination system and/or for measuring the vital signs of a patient to be examined in the magnetic examination system and for outputting respective data, and an electrical energy storage device for storing electrical energy and for providing the sensor with electrical energy.

### BACKGROUND OF THE INVENTION

A patient undergoing magnetic resonance (MR) examination, e.g. in a magnetic resonance imaging (MRI) system is typically positioned in a narrow bore within a MR magnet. During examination, the patient may be remotely monitored to determine vital signs of the patient, e.g. heartbeat, respiration, temperature and blood oxygen. A typical remote monitoring system provides in-bore sensors on the patient connected by electrical or optical cables to a monitoring unit outside of the bore. Connecting an in-bore sensor to a monitoring unit may be done with long runs of electrical or optical cables. Such cables may be a problem because they are cumbersome and can interfere with access to the patient and free movement of personnel. Further, the magnetic resonance examination system typically comprises sensor arrangements for measuring physical quantities that are indicative for the operational status of the magnetic resonance examination system. It is preferred that such sensors communicate wirelessly with a monitoring arrangement, too.

Therefore, the problem with wireless sensors is that, although they can communicate wirelessly, they still need to be powered, albeit with very little amounts of energy. Power cables would be cumbersome and/or defeat the purpose of such a sensor. Disposable batteries, on the other hand, are a nuisance to maintain.

From WO 2007/134143 A2, a wireless patient monitor for MRI is known which provides for on-board filtering of physiological signals from the patient to provide improved assessment and processing of MRI noise before the signal is affected by the transmission process. A system of powering of a wireless patient monitor using capacitors is also described.

Further, in WO 2021/130203 A1, a radio frequency (RF) transmit-receive coil for a MRI system with an integrated vital signs detector for the detection of vital signs of a patient within the MRI system is described, whereby contact sensors directly attached to the body of the patient, are replaced by a contactless system for monitoring vital signs, which makes it much easier to measure vital signs of the patient. This is achieved by a RF transmit-receive coil comprising a vital signs detector wherein the vital signs detector is integrated in the RF transmit-receive coil, wherein a pair of electrically conducting coil elements of the RF transmit-receive coil forms the vital signs detector, wherein the vital signs detector is a capacitive vital signs detector, the capacitive vital signs detector being adapted for receiving capacitive vital signs signals.

In "Energy-Harvesting Coil for Circularly Polarized Fields in Magnetic Resonance Imaging", Pavel S. Seregin, Oleg I. Burmistrov , Georgiy A. Solomakha, Egor I. Kretov, Nikita A. Olekhno, and Alexey P. Slobozhanyuk, Physical Review Applied 17, 004014 (2022), specialized radiofrequency coils and sensors are described which are placed inside a MRI scanner and considerably extend its functionality. However, since cable-connected in-bore devices have several disadvantages compared to the wireless ones, the latter are currently under active development. One of the promising concepts in wireless MRI coils is energy harvesting, which relies on converting the energy carried by the radiofrequency MRI field without the need for additional transmitters, similarly to common wireless power-transfer solutions. Therefore, a compact harvesting coil design is proposed which is based on the combination of loop and butterfly coils that allows energy harvesting of a circularly polarized field. By performing numerical simulations and experiments with commonly used 1.5 Tesla MRI scanners, it is demonstrated that the proposed approach is safe, efficient, does not decrease the quality of MRI images, and allows doubling the harvested voltage compared to the setups with linearly polarized fields.

### SUMMARY OF THE INVENTION

It is an object of the invention to provide a magnetic resonance examination system with an easy to maintain sensor.

According to the invention, this object is addressed by the subject matter of the independent claims. Preferred embodiments of the invention are described in the sub claims.

Therefore, according to the invention, a magnetic resonance examination system is provided, comprising:
a sensor for measuring physical quantities that are indicative for the operational status of the magnetic resonance examination system and/or for measuring the vital signs of a patient to be examined in the magnetic examination system and for outputting respective data,
an electrical energy storage device for storing electrical energy and for providing the sensor with electrical energy, and
an energy harvesting assembly for generating electrical power from kinetic energy received by mechanical motion of at least a part of the energy harvesting assembly and for transferring this electrical energy to the electrical energy storage device.

With an energy harvesting assembly, electrical energy is generated from movements of the whole energy harvesting assembly or at least a part of the energy harvesting assembly. Such movements can be different kinds of movements including but not limited to linear movements, movements along a curved line, harmonic movements, movements with constant velocity, accelerated movements and vibrations.

Different principles can be used for generating electrical power from kinetic energy received by mechanical motion of at least a part of the energy harvesting assembly:
Electrical energy generation using piezoelectric materials works by converting mechanical stress or strain into electrical energy, for example when the sensor is moved. Piezoelectric materials exhibit a unique property called the piezoelectric effect, which is the ability to generate an electric charge in response to mechanical stress or deformation. Piezoelectric materials are usually crystals, ceramics, or polymers that exhibit the piezoelectric effect. Common examples include quartz, lead zirconate titanate (PZT), and polyvinylidene fluoride (PVDF). When a mechanical force is applied to the piezoelectric material, it causes the material to change shape or undergo deformation. This can be a result of compression, tension, bending, or twisting forces. As the piezoelectric material deforms, it generates an electric charge. This happens because the mechanical stress causes a displacement of the positive and negative charges within the material's crystal structure, creating an electric dipole. As a result, a voltage difference is established across the material. Electrodes may be attached to the piezoelectric material to collect the generated charge. The collected charge can be stored in a capacitor, battery, or other electrical energy storage devices for later use, or the collected charge may be immediately used in an electronic circuit of the sensor.

Electrical energy generation using electrodynamic or inductive generators works by converting mechanical energy, typically in the form of rotational or linear motion, into electrical energy through the principle of electromagnetic induction. Electrodynamic or inductive generators require a source of mechanical energy to drive their motion. Here, the motion which is used for the generation of electrical energy is the movement of the energy harvesting assembly. An electrodynamic generator consists of two main components - a rotor and a stator. The rotor is the rotating part of the generator, while the stator is the stationary part. Both the rotor and stator have conductive coils, preferably made of copper or aluminum wire, wound around a magnetic core, such as iron or steel. The mechanical energy input causes the rotor to rotate or oscillate relative to the stator. This motion creates a changing magnetic field as the magnetic poles of the rotor's coils pass by the stator's coils. The changing magnetic field induces an electromotive force (EMF) or voltage in the stator's coils, according to Faraday's law of electromagnetic induction. This law states that the induced EMF is proportional to the rate of change of magnetic flux through the coil. The induced voltage in the stator coils causes an electric current to flow if a closed external circuit is connected to the generator. This electric current is the generator's output, which can be used to power the sensor and/or to charge the electrical energy storage device of the sensor.

Electrostatic generators can also be used to generate electrical energy from movements like vibrations. They are similar to an electrical capacitor in which one capacitor plate is suspended so that it can move relative to the other capacitor plate. By charging the capacitor when the capacitor plates are farther apart and discharging the capacitor when the plates are nearer to each other electrical energy can be generated. Here, the output power depends on the capacitance of the capacitor and its charging voltage.

In general, different types of electrical energy storage devices can be used for the invention. However, according to a preferred embodiment of the invention, the electrical energy storage device for storing electrical energy is a supercapacitor or a rechargeable microbattery. A supercapacitor, also known as an ultracapacitor, is an electrochemical energy storage device that can store and release large amounts of electrical energy quickly. Supercapacitors work by storing charge on the surface of two electrodes separated by an electrolyte. Unlike batteries, which store energy through chemical reactions, supercapacitors store energy in an electric field. This allows them to charge and discharge quickly, typically in a matter of seconds or less, and to last for a much longer number of charge/discharge cycles than traditional batteries. Supercapacitors are particularly useful in situations where quick bursts of energy are needed.

Although the movement of at least a part of the energy harvesting assembly may be achieved in different ways, according to a preferred embodiment of the invention, the movement of at least a part of the energy harvesting assembly is achieved by having the energy harvesting assembly attached to a movable part of the magnetic resonance examination system. For example, the movement of the movable part may be initiated by a motor or even by hand, i.e. by handling the movable part by an operator of the system. In this way, a movement of the energy harvesting assembly is achieved together with the movement of movable part of the magnetic resonance examination system.

In this respect, it is especially preferred that the movable part of the magnetic resonance examination system is a movable patient table of the magnetic resonance system. In this way, the generation of electrical energy by the energy harvesting device may be achieved by jogging the patient table to which the energy harvesting assembly is attached back and forth in a predefined way.

According to another preferred embodiment of the invention, the movable part is a gradient coil of the magnetic resonance system, preferably a gradient coil. A gradient coil is an essential component of a magnetic resonance examination system that is responsible for creating the spatially varying magnetic field required to produce high-resolution images of the human body.

A gradient coil system typically comprises three sets of coils, one for each of the three spatial dimensions (x, y, and z). When a current is passed through the gradient coils, they produce a linear magnetic field that varies along the length of the magnetic resonance scanner. By controlling the strength and timing of these magnetic field gradients, magnetic resonance scanners can precisely localize the source of the magnetic signals emanating from the human body and generate high-resolution images. Gradient coils are also used to encode spatial information into the magnetic resonance signal. By applying a series of gradient pulses with different amplitudes and directions, the scanner can encode spatial information into the magnetic resonance signal, allowing for the reconstruction of detailed three-dimensional images of the human body.

Therefore, according to a preferred embodiment of the invention, the step of moving the movable part in a predefined way is performed by energizing a gradient coil, to which the energy harvesting assembly is attached in a predefined way. Then, the generation of electrical energy by the energy harvesting device may be achieved by energizing the gradient coil coil to which the energy harvesting assembly is attached in a predefined way. This makes it possible to convert mechanical vibration energy into electrical energy. Preferably, the conversion makes use of resonance effects which makes it possible to sweep a gradient coil frequency into the regime of optimum power transfer.

In general, it would be possible that the sensor, the electrical energy storage device and the energy harvesting device are provided separate from each other in the magnetic resonance examination system. However, according to a preferred embodiment of the invention, the sensor, the electrical energy storage device and the energy harvesting assembly together form a sensor arrangement, which is arranged within a common housing. In this way, a respective sensor always carries its own energy supply and, therefore, can be applied in the magnetic resonance examination system in a versatile way.

As mentioned further above, the energy harvesting assembly may be operated on different principles. In this respect, according to a preferred embodiment of the invention, the energy harvesting assembly is equipped with a device comprising piezoelectric material for electrical energy generation. However, according to another preferred embodiment of the invention, the energy harvesting assembly is equipped with an electrodynamic generator or an inductive generator for electrical energy generation.

Further, according to a preferred embodiment of the invention, the magnetic resonance examination system comprises a monitoring arrangement for monitoring the data output by the sensor, and a wireless communication system for communication of data from the sensor to the monitoring arrangement to derive an operational status and/or patient vital sign information. In this respect, it is preferred that the wireless communication system comprises a transmitting device for transmitting data from the sensor and a receiving device for receiving data transmitted by the transmitting device at the monitoring arrangement, and that the transmitting device is powered by electrical energy generated by the energy harvesting assembly. In this way, a self-sufficient system can be provided.

The invention also relates to a method of operating a magnetic resonance examination system,
the magnetic resonance examination system comprising:
a sensor for measuring physical quantities that are indicative for the operational status of the magnetic resonance examination system and/or for measuring the vital signs of a patient to be examined in the magnetic examination system and for outputting respective data,
an electrical energy storage device for storing electrical energy and for providing the sensor with electrical energy, and
an energy harvesting assembly for generating electrical power from kinetic energy received by its mechanical motion and for transferring this electrical energy to the electrical energy storage device, wherein the energy harvesting assembly is attached to a movable part of the magnetic resonance examination system,
the method comprising the following method steps:
   detecting whether the electrical energy storage device is in a charging state which is below a predefined lower threshold, and
   if the charging state of the electrical energy storage device is below the predefined lower threshold, moving the movable part in a predefined way.

In this respect, it is especially preferred that the method further comprises the following method steps:
detecting whether the electrical energy storage device is in a charging state, which is above a predefined upper threshold and
if the charging state of the electrical energy storage device is not above the predefined upper threshold, moving the movable part in a predefined way.

In this way, it can be assured that the sensor may always be provided with sufficient electrical energy.

As already mentioned further above, according to a preferred embodiment of the invention, the movable part, to which the energy harvesting assembly is attached, may be a movable patient table of the magnetic resonance examination system, and the step of moving the movable part in a predefined way may be performed by jogging the patient table, to which the energy harvesting assembly is attached back and forth in a predefined way. According to another preferred embodiment of the invention, the movable part to which the energy harvesting assembly is attached is gradient coil of the magnetic resonance examination system and the step of moving the movable part in a predefined way is performed by energizing gradient coil, to which the energy harvesting assembly is attached, in a predefined way. Of course, the magnetic resonance examination system may be equipped with one or more sensor(s) which is/are attached to the patient table and at the same time have one or more sensor(s) which is/are attached to a coil.

Finally, the invention also relates to a computer program product comprising instructions thereon that, when the program is executed by a computer, cause the computer to control a magnetic resonance imaging system as described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a magnetic resonance examination system according to a preferred embodiment of the invention,
Fig. 2 schematically depicts a sensor arrangement according to a preferred embodiment of the invention,
Fig. 3 schematically depicts a wireless communication system according to a preferred embodiment of the invention,
Fig. 4 schematically depicts an energy harvesting assembly according to a first preferred embodiment of the invention,
Fig. 5 schematically depicts an energy harvesting assembly according to a second preferred embodiment of the invention,
Fig. 6 schematically depicts an energy harvesting assembly according to a third preferred embodiment of the invention, and
Fig. 7 depicts a method according to a preferred embodiment of the invention.

### DETAILED DESCRIPTION OF EMBODIMENTS

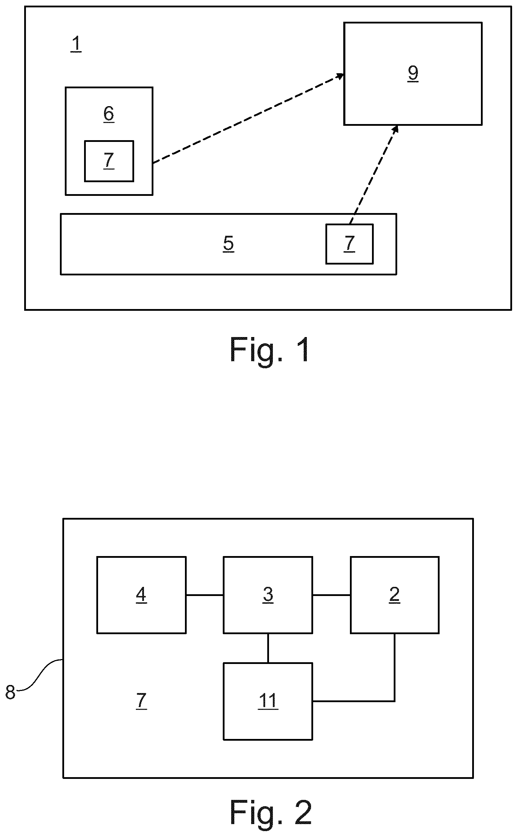

Fig. 1 schematically depicts a magnetic resonance examination 1 system according to a preferred embodiment of the invention. The magnetic resonance examination system 1 comprises, inter alia, a monitoring arrangement 9, a movable patient table 5 and a set of gradient coils from which here only a single gradient coil 6 is shown. Both, the movable patient table 5 and the gradient coil 6 are equipped with a sensor arrangement 7.

As shown in more detail in Fig. 2, the sensor arrangements 7 comprise a housing 8 which carries a sensor 2, an electrical energy storage device 3 for storing electrical energy and for providing the sensor 2 with electrical energy, and an energy harvesting assembly 4 for generating electrical power from kinetic energy received by mechanical motion of a part of the energy harvesting assembly 4 and for transferring this electrical energy to the electrical energy storage device 3.

Here, the energy storage device 3 is a supercapacitor. The sensor 2 may be a sensor for measuring physical quantities that are indicative for the operational status of the magnetic resonance examination system 1 and/or for measuring the vital signs of a patient to be examined in the magnetic examination system 1 and for outputting respective data. This data is transmitted to the monitoring arrangement 9 which is used for monitoring the data output by the sensor 2.

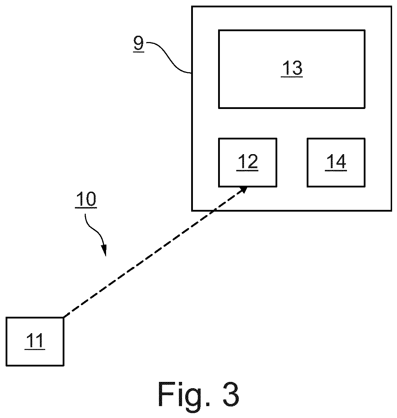

For this data transmission, as depicted in more detail in Fig. 3, a wireless communication system 10 is provided for communication of data from the sensor 2 to the monitoring arrangement 9 to derive an operational status and/or patient vital sign information. This wireless communication system 10 comprises a transmitting device 11 which is arranged within the housing 8 of the sensor arrangement 7 and a receiving device 12 which is part of the monitoring arrangement 9. Data which in this way is wirelessly transmitted from the sensor arrangement 7 to the monitoring arrangement 9 may be displayed on a display 13 of the monitoring arrangement 9.

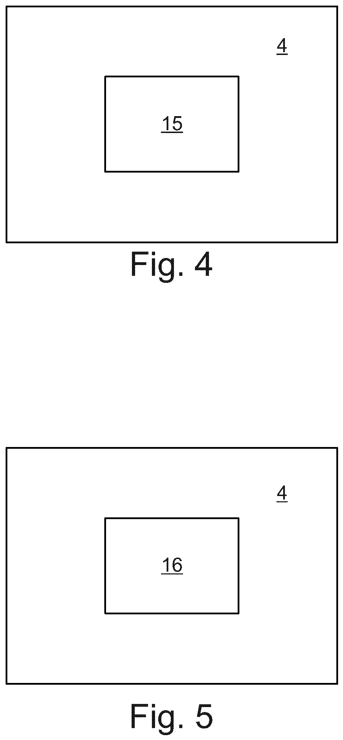

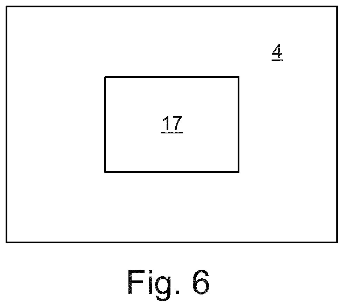

In the sensor arrangement 7, the sensor 2 and the transmitting device 11 are both powered by electrical energy which is generated by the energy harvesting assembly 4. As stated further above, the energy harvesting assembly 4 is configured for generating electrical power from kinetic energy received by mechanical motion of a part of the energy harvesting assembly 4. In this respect, the energy harvesting assembly 4 may be equipped with a device 15 comprising piezoelectric material for electrical energy generation as schematically depicted in Fig. 4. However, it is also possible that the energy harvesting assembly 4 is equipped with an electrodynamic generator 16 as schematically depicted in Fig. 5 or with an inductive generator 17 for electrical energy generation as schematically depicted in Fig. 6.

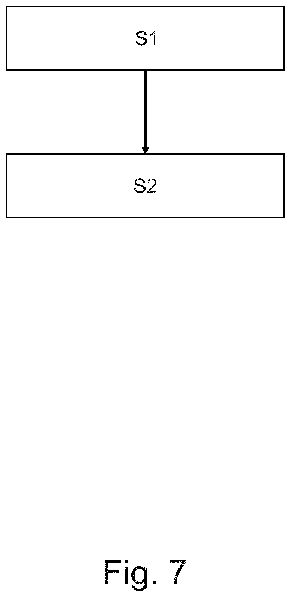

The method of operating the magnetic resonance examination system 1 described before is as follows and depicted in Fig. 7:
In step S1, it is detected whether the electrical energy storage device 3 of the sensor arrangement 7 which is attached to the patient table 5 is in a charging state which is below a predefined lower threshold. If it is detected that the charging state of the electrical energy storage device 3 is below the predefined lower threshold, in step S2, the patient table 5 to which the sensor arrangement 7 is jogged back and forth in a predefined way. In this way, the sensor arrangement 7 is moved together with the patient table 5 which means that electrical energy is generated by the energy harvesting assembly 4 of the sensor arrangement 7 and the electrical energy storage device is charged.

Then, in step S3, it is detected whether the electrical energy storage device 3 is in a charging state which is above a predefined upper threshold. This upper threshold is predefined in such a way that the charging state is sufficient for operating the sensor in a predefined way and for at least a predefined duration. If it is detected that the charging state of the electrical energy storage device 3 is not above the predefined upper threshold, in step S4 the patient table 5 to which the sensor arrangement 7 is attached again is jogged back and forth in a predefined way. Steps S3 and S4 may be repeated until a sufficient charging state which is above the predefined upper threshold is achieved.

Here, it should be mentioned that instead of or in addition to having a sensor arrangement 7 attached to a patient table 5, a sensor arrangement 7 may also be attached to a gradient coil 6 of the magnetic resonance examination system 1, especially to a gradient coil. In this situation, movement of the gradient coil 6 together with the attached sensor arrangement may be achieved by energizing the gradient coil 6. In case of a gradient coil, the energy conversion may make use of resonance effects which makes it possible to sweep a gradient coil frequency into the regime of optimum power transfer.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| magnetic resonance examination system | 1 |
| sensor | 2 |
| electrical energy storage device | 3 |
| energy harvesting assembly | 4 |
| patient table | 5 |
| gradient coil | 6 |
| sensor arrangement | 7 |
| housing | 8 |
| monitoring arrangement | 9 |
| wireless communication system | 10 |
| transmitting device | 11 |
| receiving device | 12 |
| display | 13 |
| interface | 14 |
| device comprising piezoelectric material | 15 |
| electrodynamic generator | 16 |
| inductive generator | 17 |

## Claims

1. Magnetic resonance examination system (1), comprising:
a sensor (2) for measuring physical quantities that are indicative for the operational status of the magnetic resonance examination system (1) and/or for measuring the vital signs of a patient to be examined in the magnetic examination system (1) and for outputting respective data,
an electrical energy storage device (3) for storing electrical energy and for providing the sensor (2) with electrical energy, and
an energy harvesting assembly (4) for generating electrical power from kinetic energy received by mechanical motion of at least a part of the energy harvesting assembly (4) and for transferring this electrical energy to the electrical energy storage device (3).

2. Magnetic resonance examination system (1) according to claim 1, wherein the electrical energy storage device (3) for storing electrical energy is a supercapacitor or a rechargeable microbattery.

3. Magnetic resonance examination system (1) according to any one of the preceding claims, wherein the energy harvesting assembly (4) is attached to a movable part of the magnetic resonance examination system (1).

4. Magnetic resonance examination system (1) according to any one of the preceding claims, wherein the movable part is a movable patient table (5) of the magnetic resonance system (1).

5. Magnetic resonance examination system (1) according to any one of the preceding claims, wherein the movable part is a gradient coil (6) of the magnetic resonance system (1).

6. Magnetic resonance examination system (1) according to any one of the preceding claims, wherein the sensor (2), the electrical energy storage device (3) and the energy harvesting assembly (4) together form a sensor arrangement (7) which is arranged within a common housing (8).

7. Magnetic resonance examination system (1) according to any one of the preceding claims, wherein, the energy harvesting assembly (4) is equipped with a device (15) comprising piezoelectric material for electrical energy generation.

8. Magnetic resonance examination system (1) according to any one of claims 1 to 6, wherein, the energy harvesting assembly (4) is equipped with an electrodynamic generator (16) or an inductive generator (17) for electrical energy generation.

9. Magnetic resonance examination system (1) according to any one of the preceding claims, further comprising:
a monitoring arrangement (9) for monitoring the data output by the sensor (2), and
a wireless communication system (10) for communication of data from the sensor (2) to the monitoring arrangement (9) to derive an operational status and/or patient vital sign information.

10. Magnetic resonance examination system (1) according to claim 9, wherein
the wireless communication system (10) comprises a transmitting device (11) for transmitting data from the sensor (2) and a receiving device (12) for receiving data transmitted by the transmitting device (11) at the monitoring arrangement, and
the transmitting device (11) is powered by electrical energy generated by the energy harvesting assembly (4).

11. Method of operating a magnetic resonance examination system (1),
the magnetic resonance examination system (1) comprising
a sensor (2) for measuring physical quantities that are indicative for the operational status of the magnetic resonance examination system (1) and/or for measuring the vital signs of a patient to be examined in the magnetic examination system (1) and for outputting respective data,
an electrical energy storage device (3) for storing electrical energy and for providing the sensor (2) with electrical energy, and
an energy harvesting assembly (4) for generating electrical power from kinetic energy received by its mechanical motion and for transferring this electrical energy to the electrical energy storage device (3), wherein the energy harvesting assembly (4) is attached to a movable part of the magnetic resonance examination system (1),
the method comprising the following method steps:
detecting whether the electrical energy storage device (3) is in a charging state which is below a predefined lower threshold, and
if the charging state of the electrical energy storage device (3) is below the predefined lower threshold, moving the movable part in a predefined way.

12. Method according to claim 11, comprising the following method steps:
detecting whether the electrical energy storage device (3) is in a charging state which is above a predefined upper threshold and
if the charging state of the electrical energy storage device (3) is not above the predefined upper threshold, moving the movable part in a predefined way.

13. Method according to any one of claims 11 and 12, wherein
the movable part to which the energy harvesting assembly (4) is attached is a movable patient table (5) of the magnetic resonance examination system (1) and
the step of moving the movable part in a predefined way is performed by jogging the patient table (5) to which the energy harvesting assembly (4) is attached back and forth in a predefined way.

14. Method according to any one of claims 11 and 12, wherein
the movable part to which the energy harvesting assembly (4) is attached is a gradient coil (6) of the magnetic resonance examination system (1) and
the step of moving the movable part in a predefined way is performed by energizing the gradient coil (6) to which the energy harvesting assembly (4) is attached in a predefined way.

15. A computer program product comprising instructions thereon that, when the program is executed by a computer, cause the computer to control a magnetic resonance imaging system (1) according to any one of claims 11 to 14.
